# FASCICULE DE BREVET EUROPEEN

(11) **EP 1 831 923 B1**
(45) Date de publication et mention de la délivrance du brevet: **22.05.2019**
(21) Numéro de dépôt: 05825588.6
(22) Date de dépôt: 22.12.2005
(51) Int. Cl.: H01L 21/762, H01L 21/02

(54) **PROCEDE DE DETOURAGE D'UNE STRUCTURE OBTENUE PAR ASSEMBLAGE DE DEUX PLAQUES**
VERFAHREN ZUM BESCHNEIDEN EINER MITTELS MONTAGE ZWEIER PLATTEN ERHALTENEN STRUKTUR
METHOD FOR TRIMMING A STRUCTURE OBTAINED BY THE ASSEMBLY OF TWO PLATES

(30) Priorité: 28.12.2004 FR 0413979
(43) Date de publication de la demande: 12.09.2007
(73) Titulaire: Commissariat à l'Énergie Atomique et aux Énergies Alternatives, 75015 Paris (FR); Soitec, 38190 Bernin (FR)
(72) Inventeur: ZUSSY, Marc, F-38120 Saint Egreve (FR); ASPAR, Bernard, F-38140 Rives (FR); LAGAHE-BLANCHARD, Chrystelle, F-38134 Saint Joseph de Riviere (FR); MORICEAU, Hubert, F-38120 Saint Egreve (FR)
(74) Mandataire: Ahner, Philippe
(86) Numéro de dépôt international: PCT/FR2005/051128
(87) Numéro de publication internationale: WO 2006/070160

(56) Documents cités:
- EP-A- 0 935 280
- EP-A- 1 026 728
- US-A1- 2001 055 854
- US-A1- 2002 023 725

## Description

### DOMAINE TECHNIQUE

La présente invention se rapporte à un procédé de détourage d'une structure obtenue par assemblage de deux plaques. Elle se rapporte en particulier à une structure semi-conductrice, par exemple une structure BSOI.

### ÉTAT DE LA TECHNIQUE ANTÉRIEURE

Aujourd'hui, dans le domaine de la microélectronique, de plus en plus de structures sont obtenues par assemblage de deux plaques en matériaux semi-conducteurs qui peuvent être totalement ou partiellement traitées. Par exemple, pour fabriquer une structure BSOI (pour « Bonded Silicon On Insulator »), deux plaques de silicium sont assemblées par adhésion moléculaire. De façon plus précise, cet assemblage comprend une étape de préparation de surface, une étape de mise en contact et une étape de traitement thermique par exemple à 1100°C durant 2 heures. Ensuite, au moins une des deux plaques est amincie par rectification et/ou polissage mécano-chimique.

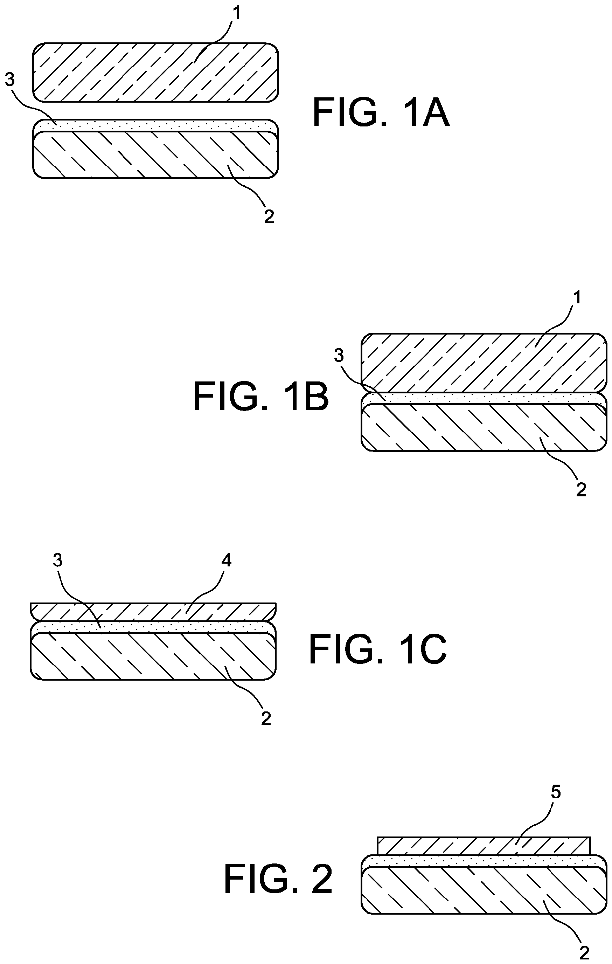

Les figures 1A à 1C illustrent un procédé classique de fabrication d'une structure BSOI.

La figure 1A représente une étape du procédé au cours de laquelle une première plaque 1 en silicium et une deuxième plaque 2 en silicium vont être mises en contact. La face de contact de la plaque 2 est la face libre d'une couche d'oxyde de silicium 3 formée sur la plaque 2. Cette couche d'oxyde de silicium peut avoir une épaisseur typiquement comprise entre 0,3 µm et 3 µm. la figure 1B représente les deux plaques 1 et 2 lors de l'étape de mise en contact adhérent (appelé « direct bonding » en anglais). La figure 1C représente la structure obtenue après amincissement de la plaque 1 pour fournir une couche mince 4 d'épaisseur comprise par exemple entre 5 µm et 100 µm.

Les plaques de silicium assemblées sont des plaques de dimension standard (de diamètre 100, 125, 150, 200 ou 300 mm) ou de tout autre dimension. Elles sont chanfreinées sur les bords, comme cela est schématisé (sans respect de l'échelle) sur les figures 1A à 1C, afin d'éviter des problèmes de casse susceptibles de se produire au cours des procédés de fabrication de composants sur les structures BSOI.

Ces chanfreins sur les bords des plaques entraînent la présence d'une zone périphérique de la couche mince non collée sur le substrat support. Cette zone périphérique doit être éliminée car elle est susceptible de se casser de façon non contrôlée et de contaminer la structure par des fragments ou particules indésirables.

Pour remédier à ce problème, on procède à une étape de détourage afin d'éliminer la zone périphérique de la couche mince. L'étape de détourage est habituellement réalisée par un moyen mécanique. La figure 2 montre la structure obtenue, la couche mince 5 ne présentant plus de zone périphérique non collée.

L'étape de détourage peut consister à usiner mécaniquement le bord de la plaque à amincir fixée sur la plaque support. Cependant, il est difficile d'usiner la plaque supérieure de la structure (c'est-à-dire la plaque à amincir) sans toucher ou endommager la plaque inférieure (ou plaque support). En effet, l'interface entre les deux plaques collées est très précise et il impossible de s'arrêter mécaniquement de façon très sûre à cette interface.

Pour pallier ce problème, le document JP-A-11-067 701 propose une première étape d'amincissement mécanique suivie, pour atteindre l'interface, d'un amincissement chimique. Cependant, entre ces deux étapes, les bords de plaques sont fragiles, ce qui peut rendre en particulier les manipulations difficiles.

Une autre possibilité consiste à usiner les bords de la plaque supérieure de la structure jusqu'à entamer sur une faible épaisseur la plaque support inférieure comme cela est illustré dans le document WO-A-96/17377. Cet usinage entraîne cependant un état de surface dont la rugosité et le niveau de contamination particulaire n'est pas toujours compatible avec le domaine de la microélectronique. Il faut alors retraiter les bords usinés pour améliorer leur état de surface, par exemple par un polissage mécano-chimique.

US 2001/055854 décrit un procédé de fabrication d'un élément semiconducteur et un procédé de fabrication d'une cellule solaire, ce procédé comprenant l'étape consistant à transférer une couche semi-conductrice sur la partie d'un second élément en séparant la partie d'une couche poreuse.

### EXPOSÉ DE L'INVENTION

La présente invention permet de remédier aux inconvénients de l'art antérieur.

Selon l'invention, on utilise la géométrie de la plaque supérieure et/ou de la plaque inférieure, due au chanfreinage, pour obtenir un détourage adapté. On utilise une solution de gravure choisie pour attaquer la plaque supérieure de la structure empilée. Cette attaque chimique peut être homogène sur toute la partie non collée de la plaque supérieure de la structure ou principalement localisée au niveau de la future couche mince.

L'invention a pour objet un procédé tel que défini par la revendication indépendante 1.

Le procédé selon l'invention permet d'obtenir le détourage le plus faible possible par rapport à la géométrie des plaques. L'opération de détourage proprement dite (correspondant à l'étape b)) est une opération de gravure chimique et non une opération mécanique. Le procédé de l'invention est également plus simple que les procédés de l'art connu puisque certaines étapes sont supprimées.

Différentes variantes de réalisation sont définies par les revendications dépendantes.

### BRÈVE DESCRIPTION DES DESSINS

L'invention sera mieux comprise et d'autres avantages et particularités apparaîtront à la lecture de la description qui va suivre, donnée à titre d'exemple non limitatif, accompagnée des dessins annexés parmi lesquels :
- les figures 1A à 1C, déjà décrites, illustrent un procédé classique de fabrication d'une structure BSOI ;
- la figure 2, déjà décrite, montre une structure BSOI détourée selon par un procédé de l'art connu ;
- les figures 3A à 3C illustrent un premier mode de mise en oeuvre du procédé selon l'invention ;
- les figures 4A à 4D illustrent un deuxième mode de mise en oeuvre du procédé selon l'invention ;
- les figures 5A à 5C illustrent un troisième mode de mise en oeuvre du procédé selon l'invention ;
- la figure 6 est un diagramme représentant la vitesse de gravure d'une solution d'attaque chimique en fonction de la température ;
- les figures 7A à 7C illustrent un quatrième mode de mise en oeuvre du procédé selon l'invention ;
- la figure 8 illustre une étape d'un cinquième mode de mise en oeuvre du procédé selon l'invention ;
- la figure 9 illustre une étape d'une variante du cinquième mode de mise en oeuvre du procédé selon l'invention.

### EXPOSÉ DÉTAILLÉ DE MODES DE RÉALISATION PARTICULIERS

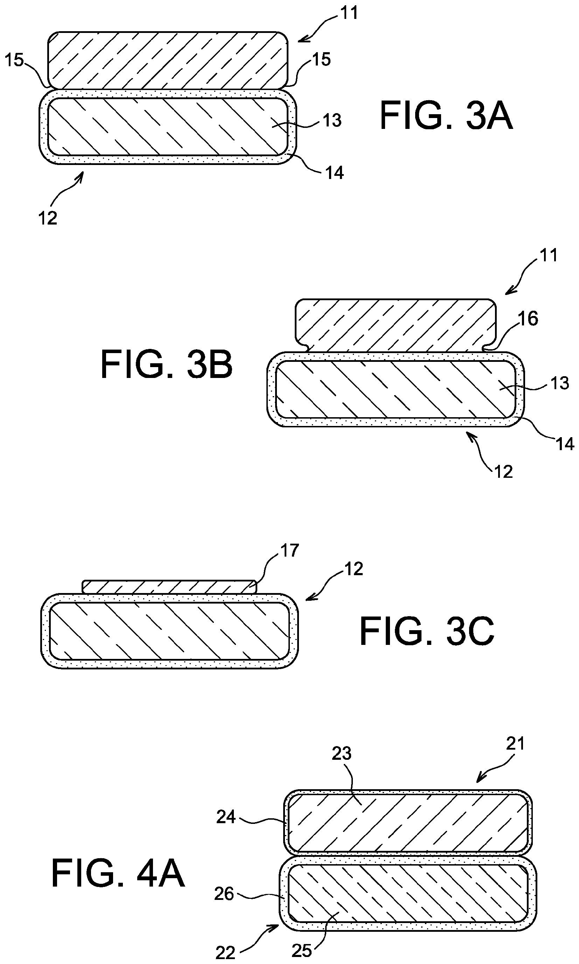

Les figures 3A à 3C sont des vues en coupe transversale illustrant un premier mode de mise en oeuvre du procédé selon l'invention.

La figure 3A montre l'assemblage d'une première plaque 11 et d'une deuxième plaque 12 fixées l'une à l'autre selon des faces de contact. La plaque 11 est une plaque de silicium. La plaque 12 est une plaque de silicium 13 recouverte d'une couche d'oxyde de silicium 14. La fixation se fait par une technique d'adhésion moléculaire bien connue de l'homme de l'art. L'adhésion se fait par exemple à température ambiante, puis est renforcée par un traitement thermique, par exemple entre 900 et 1200°C pendant 2 heures. L'atmosphère du traitement thermique peut être de l'argon avec environ 2% d'oxygène (c'est-à-dire 98% d'argon et 2% d'oxygène en volume).

La plaque 11 en silicium subit alors une désoxydation pour éliminer l'oxyde natif, par exemple par HF dilué à 10 %, et ensuite une attaque chimique par exemple par du TMAH (hydroxyde de tétraméthylammonium) ou par du KOH. On pourrait également procéder à une gravure sèche sélective. Toute la surface libre de la plaque 11 subit cette attaque chimique et en particulier la zone chanfreinée référencée 15 sur la figure 3A. L'attaque chimique est menée de manière à obtenir un piédestal 16 au niveau des faces de contact des deux plaques, le piédestal reposant entièrement sur la deuxième plaque 12 (voir la figure 3B). Si le collage est suffisamment fort, la largeur du piédestal correspond environ à la zone de collage des deux plaques. Comme détaillé plus loin, plus le collage est faible, plus le piédestal est étroit. Le piédestal peut être obtenu par une attaque chimique de la plaque 11 sur une épaisseur de l'ordre de 80 µm. Dans le cas de l'utilisation du TMAH comme produit d'attaque chimique, on peut utiliser le TMAH dilué à 25%, à une température de 80°C pendant 4 heures. Cette solution d'attaque présente l'avantage d'avoir une forte sélectivité (supérieure à 1000 entre le silicium et l'oxyde de silicium) et attaque donc très peu la couche d'oxyde 14 de la plaque 12.

Une fois le piédestal obtenu, la plaque de silicium 11, déjà légèrement amincie par l'attaque chimique, est amincie par sa face libre, par exemple par une action mécanique. On peut pour cela utiliser un procédé rapide de rectification par meulage (ou « grinding » en anglais) avec une meule de grain de l'ordre de 50 µm (référence # 325) par exemple. Ce meulage est prolongé par un rodage fin qui consiste par exemple à roder la plaque amincie avec une meule de grain de l'ordre de 8 µm (référence # 2000), voire plus fine. Cette étape permet de retirer un maximum de la zone écrouie lors du meulage précédent. L'étape d'amincissement est menée jusqu'à atteindre le piédestal.

Une éventuelle étape de polissage final peut être utilisée pour préparer un état de surface compatible par exemple avec une épitaxie. Un tel état de surface est appelé « epi-ready » par l'homme de l'art.

L'épaisseur restante après les opérations d'amincissement est déterminée en fonction de l'épaisseur nécessaire à l'application visée. L'épaisseur de la plaque 11 attaquée par la solution d'attaque chimique est donc fixée également en fonction de l'épaisseur de la couche mince 17 désirée (voir la figure 3C). Avantageusement, le piédestal aura donc, après l'étape de rectification rapide, une épaisseur supérieure à l'épaisseur de la couche mince 17. On constate alors que les bords de la structure SOI obtenue sont propres et bien définis.

En variante de cet exemple, la première plaque peut être en germanium et la deuxième plaque en silicium oxydé ou non. Une attaque par H₂O₂ chauffé à 70 °C permet de graver le germanium pour constituer le piédestal (par exemple de 60 µm de hauteur). Cette attaque n'a pas d'effet sur la deuxième plaque en silicium. L'amincissement peut ensuite permettre d'obtenir une structure SGOI, par exemple comportant une couche mince de germanium de 10 à 40 µm d'épaisseur.

Les figures 4A à 4D sont des vues en coupe transversale illustrant un deuxième mode de mise en oeuvre du procédé selon l'invention.

La figure 4A montre l'assemblage d'une première plaque 21 et d'une deuxième plaque 22 fixées l'une à l'autre selon des faces de contact. La plaque 21 est une plaque de silicium 23 recouverte d'une couche d'oxyde de silicium 24. La plaque 22 est également une plaque de silicium 25 recouverte d'une couche d'oxyde de silicium 26. Les oxydes de silicium 24 et 26 sont soit tous les deux des oxydes thermiques, soit ils sont tous les deux déposés mais l'épaisseur de la couche d'oxyde 24 est donc plus faible que l'épaisseur de la couche d'oxyde 26. Les plaques 21 et 22 ont été fixées par une technique d'adhésion moléculaire à température ambiante. L'adhésion est renforcée par un traitement thermique, par exemple entre 900 et 1200°C pendant 2 heures. L'atmosphère du traitement thermique peut être de l'argon avec 2% d'oxygène (98% d'argon et de 2% d'oxygène en volume).

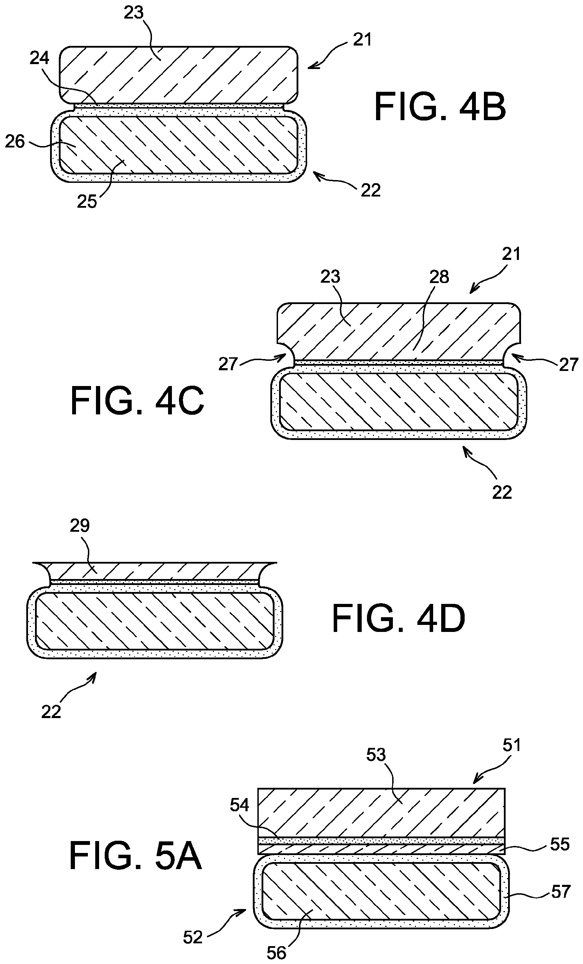

On procède ensuite à une première attaque chimique pour désoxyder la surface libre de la plaque 21. On peut utiliser pour cela du HF dilué à 10%. On obtient la structure représentée à la figure 4B qui montre que les bords libres y compris les zones chanfreinées de la plaque 21 sont désoxydées.

On procède ensuite à une deuxième attaque chimique par du TMAH dilué à 25% par exemple pour diminuer l'épaisseur de silicium de la plaque 23. Toute la surface libre de la plaque de silicium 23 subit cette attaque chimique et en particulier la zone chanfreinée inférieure 27. L'attaque chimique est menée de manière à obtenir une partie 28 de piédestal au niveau des faces de contact des plaques 21 et 22, la partie 28 reposant entièrement sur la deuxième plaque 22 par l'intermédiaire de la couche d'oxyde 24 subsistante (voir la figure 4C). Ceci peut être obtenu par une attaque chimique du silicium 23 sur une épaisseur par exemple de 80 µm. Dans le cas de l'utilisation de TMAH comme produit d'attaque chimique, la solution d'attaque peut être à une température de 80°C et l'attaque peut durer 4 heures.

L'étape suivante consiste à amincir la plaque de silicium 23 déjà partiellement amincie chimiquement. On peut pour cela avoir prévu dans cette plaque une zone fragile enterrée, par exemple par implantation d'espèces gazeuses (par exemple de l'hydrogène) au niveau de la face à assembler avant collage. On procède alors à une fracture au niveau de cette zone fragile enterrée, par exemple par traitement thermique et/ou mécanique.

Comme précédemment, la surface libre de la première plaque amincie peut être ensuite polie pour obtenir un état de surface « epi-ready ». La figure 4D montre la structure obtenue où la référence 29 désigne la partie amincie de la première plaque.

L'amincissement peut être également obtenu par diverses autres techniques choisies parmi les attaques chimiques ou des gravures sèches (ionique, ionique réactive, etc...), voire les techniques de « lift-off ».

Les figures 5A à 5C sont des vues en coupe transversale illustrant un troisième mode de mise en oeuvre du procédé selon l'invention.

La figure 5A montre l'assemblage d'une première plaque 51 et d'une deuxième plaque 52 fixées l'une à l'autre selon des faces de contact. La plaque 51 comprend un support 53, par exemple en silicium, supportant successivement une couche sacrificielle 54 et une couche mince 55. Si la couche mine 55 est en silicium, la couche sacrificielle 54 peut être en silicium poreux. La plaque 52 est une plaque de silicium 56 recouverte d'une couche de protection en oxyde de silicium 57. Les plaques 51 et 52 ont été fixées l'une à l'autre par une technique d'adhésion moléculaire à température ambiante, la couche mince 55 étant mise en contact avec la couche de protection 57.

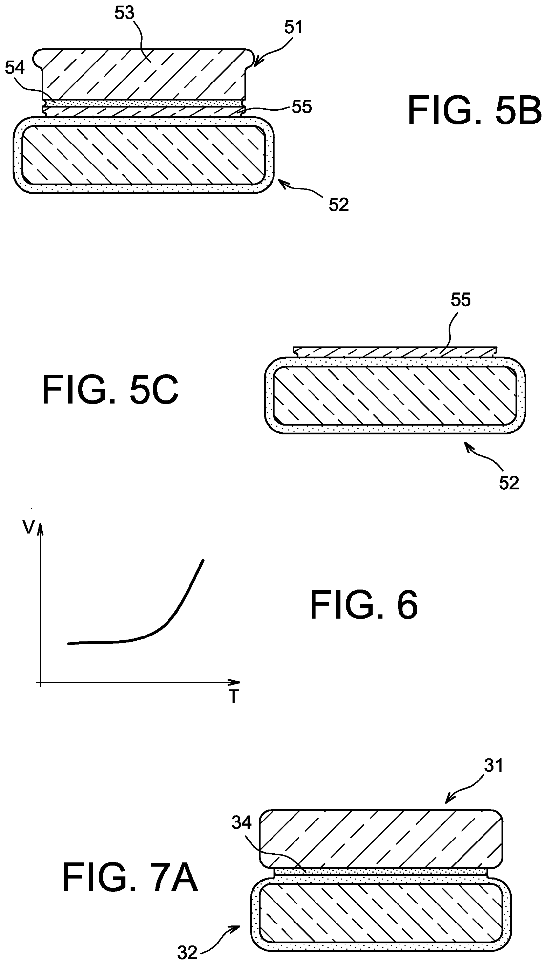

La figure 5B montre la structure obtenue après l'attaque chimique destinée à former le piédestal. L'ensemble des éléments formant la plaque 51 a été attaqué. Cette figure montre que le piédestal de la première plaque 51 repose maintenant entièrement sur la face de contact de la deuxième plaque 52.

On procède ensuite à un amincissement de la première plaque par une technique de « lift-off », en gravant sélectivement la couche sacrificielle 54. Si la couche 54 est en silicium poreux et la couche mince 55 en silicium, la gravure de la couche sacrificielle 54 peut être obtenue par un mélange d'eau, de HF et de H₂O₂. On obtient la structure représentée à la figure 5C, la couche mince 55 pouvant encore être amincie, par exemple mécaniquement.

La température de la solution d'attaque chimique (par exemple une solution de TMAH à 25%) utilisée pour obtenir le piédestal peut être modifiée pour modifier la vitesse de gravure de la première plaque (par exemple en silicium). La figure 6 donne l'allure de la courbe de vitesse de gravure V du silicium par le TMAH en fonction de la température d'attaque T.

Outre la température, la vitesse de gravure de la solution peut être modifiée si la composition de la solution d'attaque change. De même, les divers modes d'utilisation de cette solution d'attaque permettent de modifier la vitesse d'attaque (par exemple la recirculation plus ou moins importante de la solution dans un bac d'attaque, l'application de mégasons).

La cote d'enlèvement du silicium (80 µm dans les exemples précédents) peut aller de quelques dizaines de micromètres à quelques centaines de micromètres. La cote minimale à atteindre lors de cet enlèvement est avantageusement de l'ordre de la cote à atteindre après l'amincissement rapide de l'une des plaques en vue de mettre en forme la partie amincie (ou couche mince) de cette plaque. Par exemple, la cote d'enlèvement peut être de 50 µm si la couche mince à obtenir doit être de 20 µm. Au minimum, l'opération d'amincissement fin est effectuée en ayant atteint le piédestal.

Dans le cas d'une fixation par adhésion moléculaire, la température du traitement thermique mis en oeuvre pour renforcer l'adhésion moléculaire peut être située dans une gamme très large, par exemple supérieure à 100°C. Diverses techniques de nettoyage de surface peuvent être employées avant l'adhésion : préparation chimique des surfaces, activation des surfaces par plasma, UV, ozone, en combinaison ou non. L'adhésion peut aussi être effectuée sous vide partiel.

La pénétration latérale de la solution d'attaque au niveau de l'interface de collage peut être modifiée en modifiant l'énergie d'adhésion des deux plaques. Une énergie plus faible entraîne une pénétration plus importante de la solution d'attaque à l'interface de collage et donc engendre un détourage par gravure chimique plus important. La couche mince obtenue a alors un diamètre plus faible. L'énergie d'adhésion peut donc être utilisée comme moyen de contrôle de la largeur de détourage.

D'autre part, la nature de la couche de protection, un oxyde dans les exemples précédents, peut être modifiée et la solution d'attaque peut être adaptée pour effectuer l'attaque latérale.

On peut également choisir ces méthodes d'attaque pour la gravure de la couche de protection et/ou pour la réalisation du piédestal pour obtenir un bord de plaque spécifique requis pour l'application visée (rentrant ou saillant).

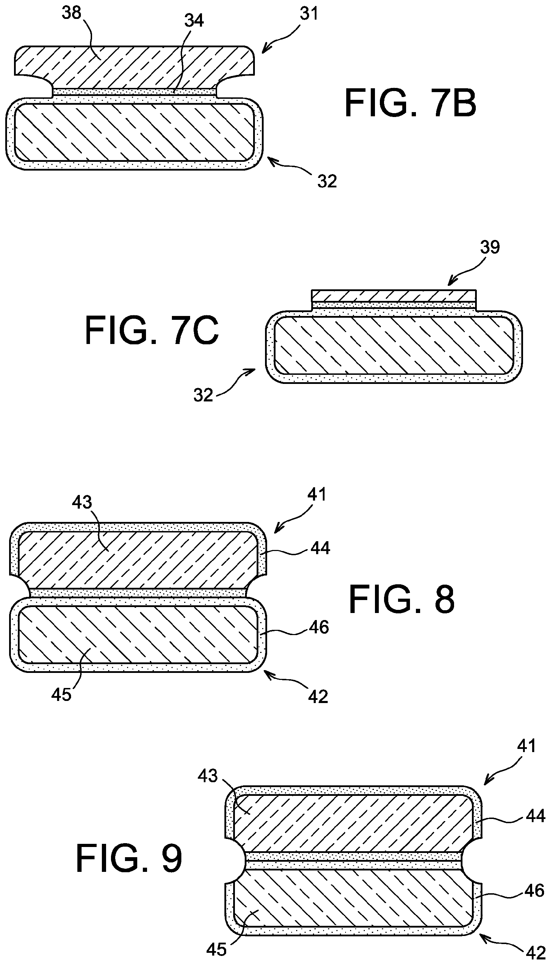

Les figures 7A à 7C sont des vues en coupe transversale illustrant un quatrième mode de mise en oeuvre du procédé selon l'invention. Ces figures sont à comparer aux figures 4B à 4D. Dans le cas de la figure 7A, l'abaissement de l'énergie de collage entre la première plaque 31 et la deuxième plaque 32 (par exemple plaques de silicium initialement recouvertes d'une couche d'oxyde de silicium) permet une attaque latérale de la couche de protection (dans l'exemple, de la couche d'oxyde) par la première attaque chimique plus importante que pour la structure de la figure 4B. La suite du procédé est identique au deuxième mode de mise en oeuvre. On retrouve sur la figure 7B la partie 28 de piédestal obtenue à l'issue de la deuxième attaque chimique. On retrouve sur la figure 7C la partie amincie 39 de la première plaque.

Un cinquième mode de mise en oeuvre du procédé selon l'invention consiste à ne retirer la couche de protection (la couche d'oxyde) de la première plaque que localement, par exemple au voisinage de l'interface de collage. C'est ce que montre la figure 8. Cette figure est une vue en coupe transversale d'une structure assemblée comprenant une première plaque 41 et une deuxième plaque 42 fixées l'une à l'autre selon des faces de contact. La plaque 41 est une plaque de silicium 43 recouverte d'une couche d'oxyde 44. La plaque 42 est une plaque de silicium 45 recouverte d'une couche d'oxyde 46.

La couche d'oxyde 44 de la plaque 41 a été éliminée uniquement au voisinage de l'interface de collage, ce qui a permis de réaliser une zone de pénétration localisée pour la deuxième attaque chimique (attaque chimique du silicium 43). On peut également prévoir d'ouvrir localement la partie de la couche 46 en regard de la zone ouverte de la couche 44, c'est-à-dire de part et d'autre de l'interface de fixation. C'est ce que représente la figure 9. Un trempage latéral dans une solution de HF à 10% pendant un temps calculé permet de retirer l'oxyde de protection. La structure obtenue est alors prête pour l'étape d'amincissement par exemple mécanique.

Le procédé selon l'invention est adapté à la réalisation de structures empilées de type silicium-sur-isolant (SOI) avec des épaisseurs de film superficiel très minces (de l'ordre du micromètre à quelques micromètres) jusqu'à des épaisseur de plusieurs dizaines de micromètres, voire plusieurs centaines de micromètres.

Le procédé selon l'invention est utilisable pour des plaques de silicium, mais aussi pour d'autres semiconducteurs (germanium, semiconducteurs III-V, etc...), pour des matériaux isolants (verre, quartz, céramique, etc...), pour des matériaux piézoélectriques (niobate de lithium, tantalate de lithium, etc...).

## Revendications

1. Procédé de détourage d'une structure obtenue par fixation d'une première plaque (11, 21, 31, 41) sur une deuxième plaque (12, 22, 32, 42) selon des faces de contact et amincissement de la première plaque, au moins l'une d'entre la première plaque et la deuxième plaque étant chanfreinée et exposant ainsi le bord de la face de contact de la première plaque, le détourage concernant la première plaque, où
le procédé comprend les étapes suivantes :
a) sélection de la deuxième plaque (12, 22, 32, 42) pour permettre la réalisation de l'étape b), ladite sélection consistant à choisir, comme deuxième plaque, une plaque dont la surface est en un matériau différent de celui de la surface de la première plaque et permettant une attaque chimique sélective de la première plaque par rapport à la deuxième plaque, ou une plaque (12, 22, 32, 42) présentant une couche (14, 26) d'au moins un matériau formant moyens d'arrêt à l'attaque chimique prévue à l'étape b) ;
b) après fixation de la première plaque sur la deuxième plaque, attaque chimique latérale de la première plaque, au niveau de l'interface de fixation, de façon à former dans la première plaque un piédestal reposant entièrement sur la face de contact de la deuxième plaque, supportant le reste de la première plaque et en retrait par rapport aux flancs de la deuxième plaque ;
c) amincissement de la première plaque jusqu'à atteindre le piédestal pour fournir une partie amincie (17, 29, 39) de la première plaque.

2. Procédé de détourage selon la revendication 1, **caractérisé en ce que** la première plaque, ou du moins sa surface, étant en silicium, la deuxième plaque est choisie parmi les plaques en quartz, en SiC, en saphir ou en silicium substitué.

3. Procédé de détourage selon la revendication 1, **caractérisé en ce que** la première plaque étant en silicium, la deuxième plaque est choisie parmi les plaques de silicium présentant une couche de matériau formant moyens d'arrêt de SiO₂ ou de Si₃N₄.

4. Procédé de détourage selon la revendication 1, **caractérisé en ce que** la face de contact de la première plaque (21, 31, 41) possède une couche de protection (24, 34, 44) à l'attaque chimique de formation du piédestal, cette couche de protection étant disposée pour ne pas empêcher la formation du piédestal.

5. Procédé de détourage selon la revendication 4, **caractérisé en ce que** ladite couche de protection (24, 34, 44) est une couche recouvrant initialement la surface de la première plaque (21, 31, 41), le procédé comprenant alors, avant l'étape d'attaque chimique de formation du piédestal, une attaque chimique de la partie de la couche de protection accessible.

6. Procédé de détourage selon revendication 5, dans lequel la deuxième plaque présente une couche d'au moins un matériau formant moyens d'arrêt à l'attaque chimique, **caractérisé en ce que** la couche d'au moins un matériau formant moyens d'arrêt à ladite attaque chimique, présente sur la deuxième plaque, et la couche de protection de la première plaque sont de natures identiques, la couche présente sur la deuxième plaque étant plus épaisse que la couche de protection de la première plaque.

7. Procédé de détourage selon les revendication 5, dans lequel la deuxième plaque présente une couche d'au moins un matériau formant moyens d'arrêt à l'attaque chimique, **caractérisé en ce que** la couche d'au moins un matériau formant moyens d'arrêt à ladite attaque chimique, présente sur la deuxième plaque, et la couche de protection de la première plaque sont de natures différentes, la couche présente sur la deuxième plaque étant, à l'étape b), attaquée plus lentement que la couche de protection de la première plaque.

8. Procédé de détourage selon l'une quelconque des revendications 1 à 7, **caractérisé en ce que** la fixation de la première plaque (11, 21, 31, 41) sur la deuxième plaque (12, 22, 32, 42) est réalisée par une technique d'adhésion moléculaire.

9. Procédé de détourage selon la revendication 8, **caractérisé en ce qu'**il est prévu de tenir compte de l'énergie de fixation entre la première plaque (31) et la deuxième plaque (32) pour obtenir une largeur déterminée de l'attaque chimique latérale de la première plaque au niveau des faces de contact.

10. Procédé de détourage selon la revendication 1, **caractérisé en ce que** la fixation de la première plaque sur la deuxième plaque se fait au moyen d'une couche de colle.

11. Procédé de détourage selon la revendication 10, **caractérisé en ce que** la couche de colle sert de moyens d'arrêt à l'attaque chimique.

12. Procédé de détourage selon la revendication 1, **caractérisé en ce que**, la première plaque (41) étant pourvue d'une couche de protection (44) à l'attaque chimique de formation du piédestal, le procédé comprend alors, avant l'attaque chimique de formation du piédestal, une attaque chimique d'élimination de la partie de la couche de protection se trouvant au niveau du futur piédestal.

13. Procédé de détourage selon la revendication 12, **caractérisé en ce que**, la deuxième plaque (42) étant également pourvue d'une couche de protection (46) à l'attaque chimique de formation du piédestal, ladite attaque chimique d'élimination de la partie de la couche de protection de la première plaque élimine également la partie de la couche de protection de la deuxième plaque se trouvant au niveau du futur piédestal en vue de créer un prolongement du piédestal dans la deuxième plaque.

14. Procédé de détourage selon l'une quelconque des revendications précédentes, **caractérisé en ce que** l'amincissement de la première plaque est réalisé par des moyens mécaniques et/ou par attaque chimique et/ou par « lift-off » et/ou par gravure sèche et/ou par fracture au niveau d'une zone fragile enterrée de la première plaque.

15. Procédé de détourage selon l'une quelconque des revendications 1 à 14, **caractérisé en ce qu'**il est prévu une étape de polissage après l'étape d'amincissement.

## Patentansprüche

1. Verfahren zum Beschnitt einer Struktur, die durch Befestigen einer ersten Platte (11, 21, 31, 41) auf einer zweiten Platte (12, 22, 32, 42) entlang Kontaktflächen und Abdünnen der ersten Platten erhalten wird, wobei wenigstens eine von der ersten Platte und der zweiten Platte abgekantet ist und somit den Rand der Kontaktfläche der ersten Platte frei legt, wobei der Beschnitt die erste Platte betrifft, wobei das Verfahren die folgenden Schritte umfasst:
a) Auswählen der zweiten Platte (12, 22, 32, 42) zum Ermöglichen der Durchführung des Schritts b), wobei das Auswählen darin besteht, als zweite Platte eine Platte zu wählen, deren Oberfläche aus einem Material ist, welches von jenem der Oberfläche der ersten Platte verschieden ist und einen selektiven chemischen Angriff auf die erste Platte bezogen auf die zweite Platte ermöglicht, oder eine Platte (12, 22, 32, 42), die eine Schicht (14, 26) von wenigstens einem Material aufweist, das Mittel zum Stoppen des im Schritt b) vorgesehenen chemischen Angriffs bildet;
b) nach dem Befestigen der ersten Platte auf der zweiten Platte, laterales chemisches Angreifen an der ersten Platte im Bereich der Befestigungsgrenzfläche derart, dass in der ersten Platte ein Sockel gebildet wird, der vollständig auf der Kontaktfläche der zweiten Platte ruht, der den Rest der ersten Platte trägt und bezogen auf die Flanken der zweiten Platte zurückgesetzt ist;
c) Abdünnen der ersten Platte, bis der Sockel erreicht wird, um einen abgedünnten Teil (17, 29, 39) der ersten Platte zu liefern.

2. Verfahren zum Beschnitt nach Anspruch 1, **dadurch gekennzeichnet, dass** die erste Platte oder wenigstens ihre Oberfläche aus Silizium ist, und dass die zweite Platte ausgewählt ist aus den Platten aus Quarz, aus SiC, aus Saphir oder aus substituiertem Silizium.

3. Verfahren zum Beschnitt nach Anspruch 1, **dadurch gekennzeichnet, dass** die erste Platte aus Silizium ist, und dass die zweite Platte ausgewählt ist aus den Platten aus Silizium, die eine ein Stoppmittel bildende Materialschicht von SiO₂ oder von Si₃N₄ aufweisen.

4. Verfahren zum Beschnitt nach Anspruch 1, **dadurch gekennzeichnet, dass** die Kontaktfläche der ersten Platte (21, 31, 41) eine Schutzschicht (24, 34, 44) gegen den chemischen Angriff zur Bildung des Sockels besitzt, wobei diese Schutzschicht derart angeordnet ist, dass sie die Bildung des Sockels nicht behindert.

5. Verfahren zum Beschnitt nach Anspruch 4, **dadurch gekennzeichnet, dass** die Schutzschicht (24, 34, 44) eine Schicht ist, die anfänglich die Oberfläche der ersten Platte (21, 31, 41) bedeckt, wobei das Verfahren dann vor dem Schritt des chemischen Angriffs zur Bildung des Sockels einen chemischen Angriff an dem zugänglichen Teil der Schutzschicht umfasst.

6. Verfahren zum Beschnitt nach Anspruch 5, bei dem die zweite Platte eine Schicht von wenigstens einem Material aufweist, das ein Stoppmittel für den chemischen Angriff bildet, **dadurch gekennzeichnet, dass** die Schicht von wenigstens einem Material, das ein Stoppmittel für den chemischen Angriff bildet, die auf der zweiten Platte vorhanden ist, und die Schutzschicht der ersten Platte von identischer Art sind, wobei die auf der zweiten Platte vorhandene Schicht dicker ist als die Schutzschicht der ersten Platte.

7. Verfahren zum Beschnitt nach Anspruch 5, wobei die zweite Platte eine Schicht von wenigstens einem Material aufweist, das ein Stoppmittel für den chemischen Angriff bildet, **dadurch gekennzeichnet, dass** die Schicht von wenigstens einem Material, das ein Stoppmittel für den chemischen Angriff bildet, die auf der zweiten Platte vorhanden ist, und die Schutzschicht der ersten Platte von unterschiedlicher Art sind, wobei die auf der zweiten Platte vorhandene Schicht im Schritt b) langsamer angegriffen wird als die Schutzschicht der ersten Platte.

8. Verfahren zum Beschnitt nach einem der Ansprüche 1 bis 7, **dadurch gekennzeichnet, dass** die Befestigung der ersten Platte (11, 21, 31, 41) auf der zweiten Platte (12, 22, 32, 42) durch eine molekulare Adhäsionstechnik realisiert wird.

9. Verfahren zum Beschnitt nach Anspruch 8, **dadurch gekennzeichnet, dass** vorgesehen ist, die Befestigungsenergie zwischen der ersten Platte (31) und der zweiten Platte (32) zu berücksichtigen, um eine bestimmte Breite des lateralen chemischen Angriffs auf die erste Platte im Bereich der Kontaktflächen zu erhalten.

10. Verfahren zum Beschnitt nach Anspruch 1, **dadurch gekennzeichnet, dass** die Befestigung der ersten Platte auf der zweiten Platte mit Hilfe einer Schicht aus Klebstoff erfolgt.

11. Verfahren zum Beschnitt nach Anspruch 10, **dadurch gekennzeichnet, dass** die Schicht aus Klebstoff als Mittel zum Stoppen des chemischen Angriffs dient.

12. Verfahren zum Beschnitt nach Anspruch 1, **dadurch gekennzeichnet, dass** die erste Platte (41) mit einer Schutzschicht (44) gegen den chemischen Angriff zur Bildung des Sockels versehen ist, wobei das Verfahren dann vor dem chemischen Angriff zur Bildung des Sockels einen chemischen Angriff zum Entfernen des Teils der Schutzschicht umfasst, der sich im Bereich des zukünftigen Sockels befindet.

13. Verfahren zum Beschnitt nach Anspruch 12, **dadurch gekennzeichnet, dass** die zweite Platte (42) ebenfalls mit einer Schutzschicht (46) gegen den chemischen Angriff zur Bildung des Sockels versehen ist, wobei der chemische Angriff zum Entfernen des Teils der Schutzschicht der ersten Plattte ebenfalls den Teil der Schutzschicht der zweiten Platte entfernt, der sich im Bereich des zukünftigen Sockels befindet, um eine Verlängerung des Sockels in der zweiten Platte zu erzeugen.

14. Verfahren zum Beschnitt nach einem der vorhergehenden Ansprüche, **dadurch gekennzeichnet, dass** das Abdünnen der ersten Platte durch mechanische Mittel und/oder durch chemischen Angriff und/oder durch "Lift-off" und/oder durch Trockenätzen und/oder durch Brechen im Bereich einer vergrabenen fragilen Zone der ersten Platte realisiert wird.

15. Verfahren zum Beschnitt nach einem der Ansprüche 1 bis 14, **dadurch gekennzeichnet, dass** ein Schritt des Polierens nach dem Schritt des Abdünnens vorgesehen ist.

## Claims

1. Method for trimming a structure obtained by bonding a first wafer (11, 21, 31, 41) onto a second wafer (12, 22, 32, 42) by contact faces and thinning of the first wafer, at least one of the first wafer and the second wafer being chamfered and thus exposing the edge of the contact face of the first wafer, wherein the trimming concerns the first wafer, wherein the method comprising the following steps:
a) selection of the second wafer (12, 22, 32, 42) to allow step b) to be carried out, said selection consisting in choosing, for the second wafer, a wafer whose surface is made of a different material from that of the surface of the first wafer and that permits selective chemical etching of the first wafer with respect to the second wafer, or a wafer (12, 22, 32, 42) with a layer (14, 26) of at least one material forming a means of stopping the chemical etching planned in step b;
b) after bonding of the first wafer to the second wafer, lateral chemical etching of the first wafer, at the level of the bonding interface, so as to form in the first wafer a pedestal resting entirely on the contact face of the second wafer, supporting the remaining of the first wafer and set back from the flanks of the second wafer;
c) thinning of the first wafer until the pedestal is reached so as to provide a thinned part (17, 29, 39) of the first wafer.

2. The method for trimming of claim 1, **characterized in that** the first wafer, or at least its surface, being made of silicon, the second wafer is chosen from the wafers made of quartz, SiC, sapphire or substituted silicon.

3. The method for trimming of claim 1, **characterized in that** the first wafer being made of silicon, the second wafer is chosen from the silicon wafers having a layer of material forming the stopping means made of SiO₂ or Si₃N₄.

4. The method for trimming of claim 1, **characterized in that** the contact face of the first wafer (21, 31, 41) has a layer (24, 34, 44) which protects against the chemical etching for forming the pedestal, wherein this protective layer is situated so as not to prevent the pedestal from being formed.

5. The method for trimming of claim 4, **characterized in that** said protective layer (24, 34, 44) is a layer that initially covers the surface of the first wafer (21, 31,41), wherein the method comprises, prior to the chemical etching step to form the pedestal, chemical etching of the accessible part of the protective layer.

6. The method for trimming of claim 5, wherein the second wafer has a layer of at least one material forming stopping means for said chemical etching, **characterized in that** the layer of at least one material forming the stopping means for said chemical etching, on the second wafer, and the protective layer of the first wafer are identical in nature, the layer on the second wafer being thicker than the protective layer of the first wafer.

7. The method for trimming of claims 5, wherein the second wafer has a layer of at least one material forming stopping means for said chemical etching, **characterized in that** the layer of at least one material forming the means of stopping said chemical etching, on the second wafer, and the protective layer of the first wafer are different in nature, the layer on the second wafer being, in step b), etched more slowly than the protective layer of the first wafer.

8. The method for trimming of any one of claims 1 to 7, **characterized in that** the first wafer (11, 21, 31, 41) is bonded onto the second wafer (12, 22, 32, 42) by a molecular adhesion technique.

9. The method for trimming of claim 8, **characterized in that** the bonding energy between the first wafer (31) and the second wafer (41) is to be taken into account to obtain a determined width of the lateral chemical etching of the first wafer at the contact faces.

10. The method for trimming of claim 1, **characterized in that** the first wafer is bonded onto the second wafer by means of a layer of glue.

11. The method for trimming of claim 10, wherein the layer of glue acts as a means of stopping the chemical etching.

12. The method for trimming of claim 1, **characterized in that**, as the first wafer (41) has a protective layer (44) against the chemical etching for forming the pedestal, the method thus comprises, prior to the chemical etching for forming the pedestal, chemical etching for eliminating the part of the protective layer located at the level of the future pedestal.

13. The method for trimming of claim 12, **characterized in that**, as the second wafer (42) also has a protective layer (46) against the chemical etching for forming the pedestal, said chemical etching to eliminate the protective layer of the first wafer also eliminates the part of the protective layer of the second wafer that is located at the level of the future pedestal in order to create an extension of the pedestal in the second wafer.

14. The method for trimming of one of the preceding claims, **characterized in that** the thinning of the first wafer is achieved by mechanical and/or chemical etching and/or "lift-off" and/or dry etching means and/or fracture at a buried fragile zone of the first wafer.

15. The method for trimming of one of claims 1 to 14, **characterized in that** a polishing step is included after the thinning step.
